# EUROPÄISCHE PATENTANMELDUNG

(11) **EP 3 386 035 A1**
(43) Veröffentlichungstag der Anmeldung: **10.10.2018**
(21) Anmeldenummer: 18165067.2
(22) Anmeldetag: 29.03.2018
(51) Int. Cl.: H01R 12/71, H01R 13/24, H01R 13/11

(54) **KONTAKTBUCHSE**

(30) Priorität: 03.04.2017 DE 102017107142
(71) Anmelder: TKR Spezialwerkzeuge GmbH, 58285 Gevelsberg (DE)
(72) Erfinder: Kreischer, Torsten, 58300 Wetter (DE)
(74) Vertreter: Kalkoff & Partner

(57) **Zusammenfassung**

Die Erfindung betrifft eine Kontaktbuchse (1) zur Aufnahme einer mindestens einen elektrisch leitenden Kontaktstift aufweisenden Steckereinheit, mit einer mit dem Kontaktstift kontaktierbaren Leiterplatte (3) und einer ein Kontaktstiftgehäuse aufnehmenden Buchsenöffnung (5). Um eine Kontaktbuchse bereitzustellen, deren Kontaktierung von Kontaktstift und Leiterplatte im Wesentlichen unabhängig von den Steckzyklen ist, ist vorgesehen, dass an der Leiterplatte ein vom Buchsenöffnungsgrund in die Buchsenöffnung vorstehendes Kontaktelement angeordnet ist, das mit einer Stirnfläche des Kontaktstifts in Eingriff bringbar ist und als in Richtung auf die Leiterplatte längenveränderlicher Druckfederkörper (4a, 4b) ausgebildet ist.

## Beschreibung

Die Erfindung betrifft eine Kontaktbuchse zur Aufnahme einer mindestens einen elektrisch leitenden Kontaktstift aufweisenden Steckereinheit, mit
- einer mit dem Kontaktstift kontaktierbaren Leiterplatte und
- einer ein Kontaktstiftgehäuse aufnehmenden Buchsenöffnung.

Kontaktbuchsen der eingangs genannten Art werden insbesondere in Kraftfahrzeugen u. a. dazu verwendet, um verschiedene elektronische Fahrzeugkomponenten miteinander zu verbinden. Die Kontaktbuchsen und die mit diesen zu verbindenden Steckereinheiten sind dabei aufeinander abgestimmt. Im Inneren der Kontaktbuchse sind dabei Anschlusskontakte für die Kontaktstifte der Steckereinheiten angeordnet, über die im montierten Zustand von Steckereinheit und Kontaktbuchse eine elektrisch leitende Verbindung hergestellt wird. Die Anschlusskontakte sind bspw. auf einer in der Kontaktbuchse angeordneten Leiterplatte angeordnet oder mit der Leiterplatte verbunden. Die Gehäuse von Kontaktbuchse und Steckereinheit sind dabei in ihrer Form so aufeinander abgestimmt, dass im montierten Zustand von Kontaktbuchse und Steckereinheit eine zuverlässige Anordnung der Gehäuse aneinander gewährleistet ist.

Im montierten Zustand von Kontaktbuchse und Steckereinheit muss ferner gewährleistet werden, dass die Kontaktstifte elektrisch leitend mit den zugeordneten Kontakten an der Kontaktbuchse verbunden sind. Eine fehlerhafte oder unzulängliche Kontaktierung führt zu Übertragungsproblemen über die mittels Kontaktbuchse und Steckereinheit hergestellte Verbindung, was zu Störungen einzelner Systeme im Kraftfahrzeug oder sogar zum vollständigen Ausfall des Kraftfahrzeugs führen kann.

Eine solche Störung kann insbesondere dann auftreten, wenn die Steckverbindung mehrfach getrennt wurde, da bekannte Kontaktbuchsen der eingangs genannten Art den Nachteil aufweisen, dass diese nur bei einer geringen Anzahl von Steckzyklen eine zuverlässige elektrisch leitende Verbindung im montierten Zustand von Steckereinheit und Kontaktbuchse gewährleisten. Insbesondere im Anschluss an eine Kfz-Reparatur kann es somit in Folge wiederholter Trennungen von Kontaktbuchse und Steckereinheit dazu kommen, dass es aufgrund der damit einhergehenden Anzahl an Steckzyklen zu einer Störung der elektrisch leitenden Verbindung kommt. Darüber hinaus weisen die bekannten Kontaktbuchsen den Nachteil auf, dass diese auf der den Kontaktstiften abgewandten Seite der Leiterplatten einen erheblichen Bauraum für solche Bauelemente benötigen, die die Kontaktstifte in ihrer Position an den Kontakten der Leiterplatte sichern.

Hiervon ausgehend liegt der Erfindung die Aufgabe zugrunde, eine Kontaktbuchse bereitzustellen, deren Kontaktierung von Kontaktstift und Leiterplatte im Wesentlichen unabhängig von den Steckzyklen ist.

Die Erfindung löst die Aufgabe durch eine Kontaktbuchse mit den Merkmalen des Anspruchs 1. Vorteilhafte Weiterbildungen der Erfindung sind in den abhängigen Ansprüchen angegeben.

Kennzeichnend für die erfindungsgemäße Kontaktbuchse ist, dass an der Leiterplatte ein vom Buchsenöffnungsgrund in die Buchsenöffnung vorstehendes Kontaktelement angeordnet ist, das mit einer Stirnfläche des Kontaktstifts einer Steckereinheit in Eingriff bringbar ist und als in Richtung auf die Leiterplatte längenveränderlicher Druckfederkörper ausgebildet ist. Unter längenveränderlich wird dabei die Eignung der Druckfederkörper angesehen, die Erstreckung in Längsachsenrichtung elastisch zu verändern. Eine elastische Verformung erfolgt dabei durch die Montage der Steckereinheit an der Kontaktbuchse, bei der der Druckfederkörper durch den Kontaktstift in Richtung auf die Leiterplatte elastisch verformt wird.

Gemäß der Erfindung ist dabei der mit dem Kontaktstift der Steckereinheit zu kontaktierende Kontakt auf der Leiterplatte mit einem als Druckfederkörper ausgebildeten Kontaktelement verbunden, welches mit seinem der Leiterplatte gegenüberliegenden freien Ende von einem Buchsenöffnungsgrund der Kontaktbuchse in die Buchsenöffnung vorsteht.

Die Ausgestaltung des Kontaktelements als Druckfederkörper ist dabei derart, dass bei einer Verbindung von Kontaktbuchse und Steckereinheit eine oder mehrere Kontaktstifte der Steckereinheit mit ihren Stirnflächen an den zugeordneten Druckfederkörpern anliegen. In der montierten Lage bewirkt die durch die Kontaktstifte hervorgerufene elastische Verformung der Druckfederkörper eine kraftschlüssige Anlage der Druckfederkörper an den Stirnseiten der Kontaktstifte. Die Kontaktstifte können dabei grundsätzlich jede beliebige Form aufweisen, bspw. als Flachstecker oder zylindrische Stifte ausgebildet sein, wobei ggf. die Druckfederkörper bevorzugt entsprechend ausgebildete Anlageflächen aufweisen, sodass im Falle einer Montage die Stirnseiten der Kontaktstifte zuverlässig an den Druckfederkörpern zur Anlage kommen und diese elastisch verformen, sodass deren Längserstreckung in Richtung auf die Kontaktstifte verändert wird.

Die Ausgestaltung der Kontaktstifte als in Längsachsenrichtung der Buchsenöffnungen bzw. in Richtung auf die Leiterplatte längenveränderliche Druckfederkörper ermöglicht es, die durch die Bewegung der Kontaktstifte beim Verbinden von Steckereinheit und Kontaktbuchse auftretende Verlagerung dazu zu verwenden, die Druckfederkörper elastisch zu verformen, sodass die Rückverformungsenergie eine zuverlässige Anlage der Kontaktstifte an den mit der Leiterplatte verbundenen Druckfederkörpern gewährleistet. Eine Auslegung der Druckfederkörper derart, dass diese bei einer Kontaktierung von Kontaktbuchse und Steckereinheit nur im elastischen Bereich verformt werden, gewährleistet dabei in besonders zuverlässiger Weise, dass steckzyklenunabhängig eine zuverlässige Kontaktierung gewährleistet ist.

Die Ausgestaltung des Druckfederkörpers derart, dass dieser bei einem Einführen des Kontaktstifts in die Kontaktbuchse und beim Verbinden von Kontaktbuchse und Steckereinheit eine elastische Verformung erfährt, ist grundsätzlich frei wählbar. So kann der Druckfederkörper bspw. als Schraubendruckfeder ausgelegt sein, welche einenends an der Leiterplatte angeordnet ist und anderenends zur Kontaktierung mit dem Kontaktstift der Steckereinheit ausgebildet ist, welcher in der montierten Lage von Steckereinheit und Kontaktbuchse eine Verformung der Schraubendruckfeder im elastischen Bereich bewirkt.

Nach einer besonders vorteilhaften Ausgestaltung der Erfindung ist jedoch vorgesehen, dass der Druckfederkörper mindestens einen gegenüber der Buchsenöffnungslängsachse geneigten Deformationsabschnitt aufweist. Gemäß dieser Ausgestaltung der Erfindung ist vorgesehen, dass der Druckfederkörper zumindest einen Abschnitt aufweist, welcher sich quer zur Längsachse der Buchsenöffnung erstreckt, d. h. unter einem Winkel kleiner als 90° und größer als 0° zur Längsachse verläuft. Die Längsachse der Buchsenöffnung entspricht dabei der Achse, entlang derer sich der Kontaktstift bei der Montage der Steckereinheit an der Kontaktbuchse bewegt. Die Verwendung eines geneigten Deformationsabschnittes gewährleistet in besonders einfacher Weise die Ausbildung eines elastisch verformbaren Druckfederkörpers, wobei im Zusammenwirken mit dem Kontaktstift in der Regel die Neigung des Deformationsabschnittes gegenüber der Buchsenöffnungslängsachse erhöht wird. In einer besonders einfachen Ausgestaltung kann bspw. der Druckfederkörper Z-förmig ausgestaltet sein, wobei dieser einenends an der Leiterplatte anliegt und anderenends zum Kontakt mit dem Kontaktstift ausgebildet ist.

Eine Kontaktierung des Kontaktstifts mit dem Druckfederkörper ist bei einer entsprechenden Ausgestaltung des Druckfederkörpers grundsätzlich besonders einfach realisierbar. Nach einer besonders vorteilhaften Ausgestaltung der Erfindung ist jedoch vorgesehen, dass das freie Ende des Druckfederkörpers einen im Wesentlichen senkrecht zur Buchsenöffnungslängsachse verlaufenden Kontaktabschnitt aufweist. Die Anordnung eines quer zur Einschubrichtung des Kontaktstifts in die Buchsenöffnung verlaufenden Kontaktabschnitts gewährleistet in besonders zuverlässiger Weise, dass der Kontaktstift mit seiner Stirnseite zuverlässig an dem Druckfederkörper anliegt. Bei einem als Flachstecker ausgebildeten Kontaktstift ermöglicht bspw. die Verwendung eines quer zur Buchsenöffnungslängsachse verlaufenden Kontaktabschnitts eine breite Kontaktfläche zwischen dem Kontaktstift und dem Kontaktelement, sodass zuverlässig sowohl eine elektrisch leitende Verbindung hergestellt wird als auch eine ausreichende Anlage des Druckfederkörpers an dem Kontaktstift besteht.

Die Lagesicherung des Druckfederkörpers innerhalb der Kontaktbuchse und dessen Kontaktierung mit der Leiterplatte kann grundsätzlich in beliebiger Weise erfolgen. Nach einer besonders vorteilhaften Ausgestaltung der Erfindung ist jedoch vorgesehen, dass der Druckfederkörper durch eine Öffnung in einem den Buchsenöffnungsgrund bildenden Buchsenboden hindurchragt.

Gemäß dieser Ausgestaltung der Erfindung ist die Buchsenöffnung durch einen Buchsenboden begrenzt, welcher Öffnungen aufweist, durch die eine oder mehrere mit der Leiterplatte verbundene Druckfederkörper hindurchragen. Die Verwendung eines mit Öffnungen versehenen Buchsenbodens gewährleistet durch die Öffnungen eine zuverlässige Lagesicherung der Druckfederkörper. Diese sind durch die Öffnung randseitig geführt, sodass einer fehlerhaften Ausweichbewegung der Druckfederkörper im Zusammenwirken mit den Kontaktstiften vorgebeugt wird. Darüber hinaus ermöglicht diese Ausgestaltung der Erfindung auch eine zuverlässige Lagesicherung der Druckfederkörper an den Kontakten der Leiterplatte, welche besonders bevorzugt auf der der Buchsenöffnung gegenüberliegenden Seite an dem Buchsenboden anliegt, sodass die Kontaktbuchse eine besonders geringe Bauhöhe aufweist.

Die Befestigung der Leiterplatte an der Kontaktbuchse ist dabei ebenfalls grundsätzlich frei wählbar. Nach einer besonders vorteilhaften Ausgestaltung der Erfindung ist die Leiterplatte jedoch an dem Buchsenboden befestigt, insbesondere mit diesem verschraubt. Eine entsprechende Ausgestaltung der Erfindung gewährleistet eine zuverlässige Lagesicherung der Leiterplatte an der Kontaktbuchse, wobei im Falle der vorteilhafterweise vorgesehenen Ausgestaltung der Erfindung, wonach die Druckfederkörper durch Öffnungen in dem Buchsenboden ragen, durch eine Befestigung der Leiterplatte an dem Buchsenboden, insbesondere durch eine Verschraubung eine besonders zuverlässige Lagesicherung der Druckfederkörper innerhalb der Buchsenöffnung erreicht werden kann.

Die Verbindung der als Druckfederkörper ausgebildeten Kontaktelemente mit den entsprechenden Kontakten an der Leiterplatte ist grundsätzlich frei wählbar. So können diese bspw. durch geeignete Kleber elektrisch leitend mit den Kontaktstellen an der Leiterplatte verbunden werden. Nach einer besonders vorteilhaften Ausgestaltung der Erfindung ist jedoch vorgesehen, dass die Druckfederkörper an die Leiterplatte angelötet sind. Die Lötverbindung lässt sich besonders einfach und kostengünstig herstellen und gewährleistet in besonders zuverlässiger Weise eine elektrische Kontaktierung der Druckfederkörper mit der Leiterplatte.

Nach einer weiteren Ausgestaltung der Erfindung ist ferner vorgesehen, dass die Leiterplatte an einem Gehäusedeckel anliegt. Gemäß dieser Ausgestaltung der Erfindung wird ein Gehäusekörper der Kontaktbuchse durch einen Gehäusedeckel verschlossen, welcher unmittelbar an der Leiterplatte anliegt und diese somit in ihrer Position innerhalb der Kontaktbuchse sichert. Darüber hinaus wird durch eine Anlage des Gehäusedeckels an der Leiterplatte, wobei die Anlage auch punktuell ausgeführt sein kann, gewährleistet, dass die Bauhöhe der Kontaktbuchse besonders gering ausgestaltet ist.

Ein Ausführungsbeispiel der Erfindung wird nachstehend mit Bezug auf die Zeichnungen erläutert. In den Zeichnungen zeigen:
- Figur 1: eine erste Explosionsdarstellung einer Kontaktbuchse und
- Figur 2: eine zweite Explosionsdarstellung der Kontaktbuchse von Figur 1.

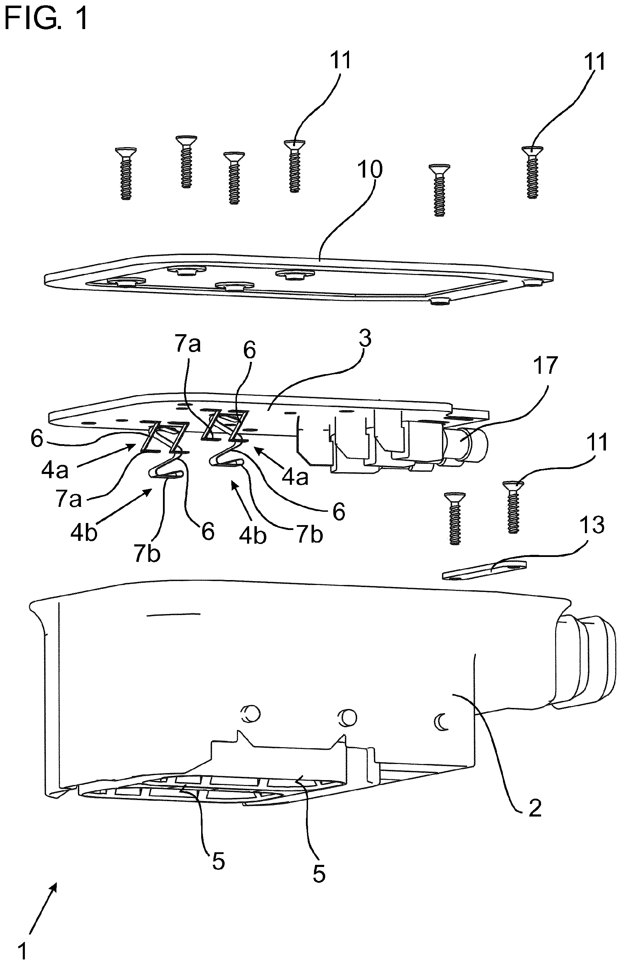

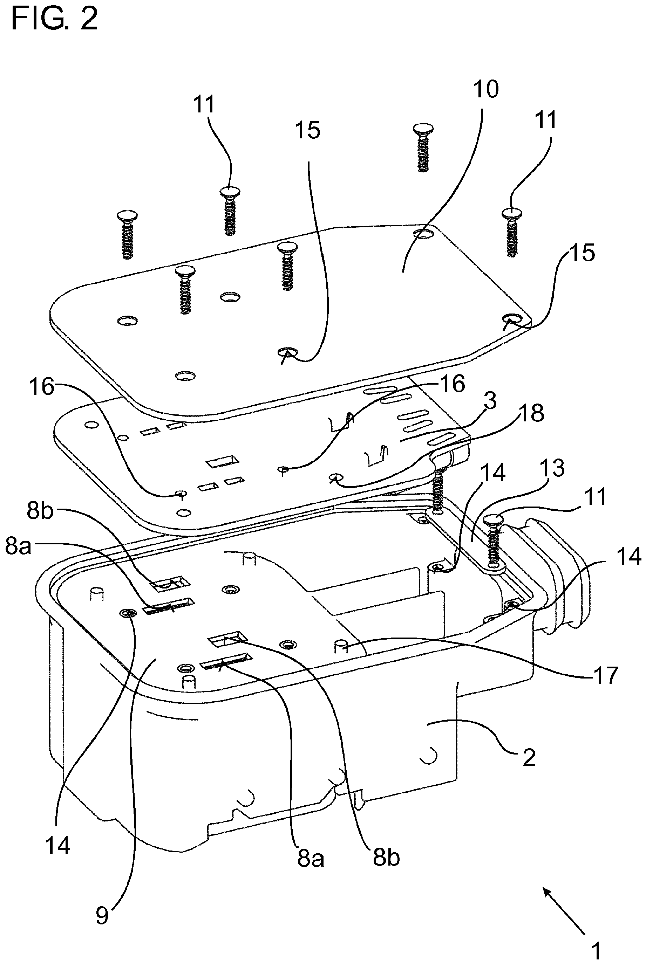

Ein Ausführungsbespiel einer Kontaktbuchse 1 ist in den Figuren 1 und 2 in zwei unterschiedlichen Ansichten jeweils in einer Explosionsdarstellung wiedergegeben.

Die Kontaktbuchse 1 weist ein Buchsengehäuse 2 auf, welches in dem dargestellten Ausführungsbeispiel zwei Buchsenöffnungen 5 für eine hier nicht dargestellte Steckereinheit aufweist, wobei die Buchsenöffnungen 5 dann zur Aufnahme eines Kontaktstiftgehäuses der Steckereinheit dienen.

Die Buchsenöffnungen 5 sind in Einschubrichtungen der Steckereinheit durch einen Buchsenboden 9 begrenzt, welcher den Grund der Buchsenöffnung 5 bildet. Der Buchsenboden 9 weist Öffnungen 8a, 8b auf, welche zur Aufnahme von als Kontaktelementen ausgebildeten Druckfederkörpern 4a, 4b dienen, welche mit ihren den freien Enden gegenüberliegenden Enden mit einer Leiterplatte 3 verbunden sind. Die Leiterplatte 3 liegt auf der der Buchsenöffnung 5 gegenüberliegenden Seite an dem Buchsenboden 9 an, wobei im montierten Zustand der Leiterplatte 3 an dem Buchsenboden 9 Zapfen 17 an dem Buchsenboden 9 durch Zapfenaufnahmen 18 an der Leiterplatte 3 hindurchragen.

Die Druckfederkörper 4a, 4b, welche an vorgesehene Kontakte an der Leiterplatte 3 angelötet sind, weisen an ihrem freien Ende jeweils einen im Wesentlichen senkrecht zur Längsachse der Buchsenöffnung 5 verlaufende Kontaktabschnitt 7a, 7b auf. Die Kontaktabschnitte 7a, 7b sind entsprechend der Stirnseiten der hier nicht dargestellten Kontaktstifte der Steckereinheit ausgebildet, um so eine zuverlässige Anlage aneinander zu gewährleisten. Im montierten Zustand der Steckereinheit an der Kontaktbuchse 1 verlagern die Kontaktstifte die Kontaktabschnitte 7a, 7b in Richtung auf die Leiterplatte 3, wobei im Bereich zwischen der Leiterplatte 3 und den Kontaktabschnitten 7a, 7b angeordnete Deformationsabschnitte 6 der Druckfederkörper 4a, 4b elastisch verformt werden. Hierdurch verringert sich die Längserstreckung der Druckfederkörper 4a, 4b in Längsachsenrichtung der Buchsenöffnungen. Die durch die Kontaktstifte bei der Montage der Steckereinheit an der Kontaktbuchse 1 hervorgerufene Verformung der Druckfederkörper 4a, 4b ist elastisch, sodass die sich aufgrund der elastischen Verformung aufbauende Federkraft eine zuverlässige Anlage der Druckfederkörper 4a, 4b an den Kontaktstiften gewährleistet. Im vorliegenden Ausführungsbeispiel sind an der Leiterplatte 3 zwei unterschiedliche Arten von Druckfederkörpern 4a, 4b angeordnet, wobei Druckfederkörper 4a Z-förmig ausgebildet sind und einen Deformationsbereich 6 aufweisen. Die Druckfederkörper 4b besitzen hingegen einen wellenförmigen, zwei Abschnitte aufweisenden Deformationsbereich 6.

Die Leiterplatte 10 ist neben den Zapfen 17 zusätzlich über Schrauben 11 an dem Buchsenboden 9 gesichert, wobei sich die Schrauben 11 durch Bohrungen 15 in dem Gehäusedeckel 10 sowie Öffnungen 16 in der Leiterplatte 3 erstrecken und in Schraubenaufnahmen 14 in dem Buchsenboden 9 eingeschraubt sind. Eine ergänzende Lagesicherung der Leiterplatte 3 wird durch weitere Schrauben 11 gewährleistet, welche sich durch Bohrungen 15 in dem Gehäusedeckel 10 in Schraubenaufnahmen 14 des Buchsengehäuses 2 erstrecken. Für eine Zugentlastung eines mit Flachsteckhülsen 12 an der Leiterplatte 3 verbundenen, hier nicht dargestellten Kabels dient ein Zugentlastungselement 13, welches durch das Einschrauben von Schrauben 11 in weitere Schraubenaufnahmen 14 an dem Buchsengehäuse 2 festklemmt wird.

### Bezugszeichenliste

- 1: Kontaktbuchse
- 2: Buchsengehäuse
- 3: Leiterplatte
- 4a, 4b: Kontaktelement/Druckfederkörper
- 5: Buchsenöffnung
- 6: Deformationsabschnitt
- 7a, 7b: Kontaktabschnitt
- 8a, 8b: Öffnung
- 9: Buchsenboden
- 10: Gehäusedeckel
- 11: Schrauben
- 12: Flachsteckhülse
- 13: Zugentlastungselement
- 14: Schraubenaufnahmen
- 15: Bohrungen
- 16: Öffnungen
- 17: Zapfen
- 18: Zapfenaufnahme

## Patentansprüche

1. Kontaktbuchse zur Aufnahme einer mindestens einen elektrisch leitenden Kontaktstift aufweisenden Steckereinheit, mit
- einer mit dem Kontaktstift kontaktierbaren Leiterplatte und
- einer ein Kontaktstiftgehäuse aufnehmenden Buchsenöffnung
**dadurch gekennzeichnet, dass**
an der Leiterplatte (3) ein vom Buchsenöffnungsgrund in die Buchsenöffnung (5) vorstehendes Kontaktelement angeordnet ist, das mit einer Stirnfläche des Kontaktstifts in Eingriff bringbar ist und als in Richtung auf die Leiterplatte (3) längenveränderlicher Druckfederkörper (4a, 4b) ausgebildet ist.

2. Kontaktbuchse nach Anspruch 1, **dadurch gekennzeichnet, dass** der Druckfederkörper (4a, 4b) mindestens einen gegenüber der Buchsenöffnungslängsachse geneigten Deformationsabschnitt (6) aufweist.

3. Kontaktbuchse nach Anspruch 1 oder 2, **dadurch gekennzeichnet, dass** das freie Ende des Druckfederkörpers (4a, 4b) einen im Wesentlichen senkrecht zur Buchsenöffnungslängsachse verlaufenden Kontaktabschnitt (7a, 7b) aufweist.

4. Kontaktbuchse nach einem oder mehreren der vorhergehenden Ansprüche, **dadurch gekennzeichnet, dass** der Druckfederkörper (4a, 4b) durch eine Öffnung (8a, 8b) in einem den Buchsenöffnungsgrund bildenden Buchsenboden (9) hindurchragt.

5. Kontaktbuchse nach einem oder mehreren der vorhergehenden Ansprüche, **dadurch gekennzeichnet, dass** die Leiterplatte (3) an dem Buchsenboden (9) befestigt ist, insbesondere mit diesem verschraubt ist.

6. Kontaktbuchse nach einem oder mehreren der vorhergehenden Ansprüche, **dadurch gekennzeichnet, dass** der Druckfederkörper (4a, 4b) an die Leiterplatte (3) angelötet ist.

7. Kontaktbuchse nach einem oder mehreren der vorhergehenden Ansprüche, **dadurch gekennzeichnet, dass** die Leiterplatte (3) an einem Gehäusedeckel anliegt.
